# EUROPEAN PATENT SPECIFICATION

(11) **EP 1 593 212 B1**
(45) Date of publication and mention of the grant of the patent: **19.04.2017**
(21) Application number: 04711064.8
(22) Date of filing: 13.02.2004
(51) Int. Cl.: H04W 76/02, H04W 72/04

(54) **APPARATUS AND METHOD FOR FAST CALL SETUP IN A MOBILE COMMUNICATION SYSTEM**
VORRICHTUNG UND VERFAHREN FÜR SCHNELLEN VERBINDUNGSAUFBAU IN EINEM MOBILKOMMUNIKATIONSSYSTEM
APPAREIL ET PROCEDE PERMETTANT D'ETABLIR RAPIDEMENT DES COMMUNICATIONS DANS UN SYSTEME DE COMMUNICATIONS MOBILE

(30) Priority: 13.02.2003 KR 2003009146
(43) Date of publication of application: 09.11.2005
(73) Proprietor: Samsung Electronics Co., Ltd., Suwon-si, Gyeonggi-do, 443-742 (KR)
(72) Inventor: KIM, Dae-Gyun 228-1703, Sibeom Woosung APT., Gyeonggi-do 463-050 (KR); LEE, Hyeon-Woo 806-901, Byucksan APT., Gyeonggi-do 441-390 (KR); BAE, Beom-Sik 142-1203, Hwanggolmaeul Jugong APT., Gyeonggi-do 442-470 (KR); CHUN, Kyong-Joon, Bangi-dong, Songpa-gu Seoul 138-050 (KR); JUNG, Jung-Soo 1807-1, Seongsu Academy Tower, Seoul 133-123 (KR)
(74) Representative: Grünecker Patent- und Rechtsanwälte PartG mbB
(86) International application number: PCT/KR2004/000300
(87) International publication number: WO 2004/073212

(56) References cited:
- WO-A1-96/37079
- WO-A1-02/067559
- JP-A- 05 110 506
- JP-A- 10 285 659
- JP-A- 11 008 584
- KR-A- 20000 034 220
- US-A- 5 940 515
- US-A1- 2002 080 943
- US-B1- 6 424 835

## Description

### BACKGROUND OF THE INVENTION

### 1. Field of the Invention

The present invention relates generally to call setup in a mobile communication system, and in particular, to an apparatus and method for more rapidly performing call setup.

### 2. Description of the Related Art

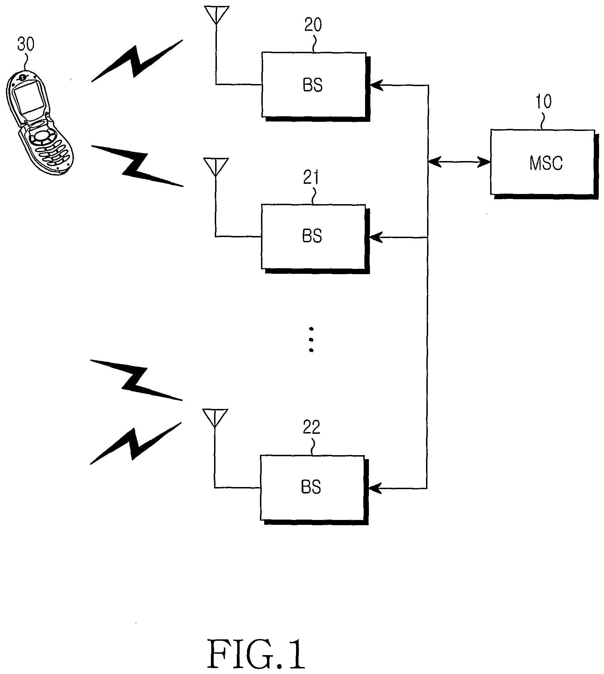

FIG. 1 is a diagram illustrating a configuration of a typical cellular mobile communication system. As illustrated in FIG. 1, a cellular mobile communication system includes a plurality of small service areas called "cells" defined by dividing its entire service area into a plurality of areas each of which is covered by one of base stations (BSs) 20, 21 and 22. In the cellular mobile communication system, the base stations 20, 21 and 22 are controlled by a mobile switching center (MSC) 10 on a centralized basis so that users can continue a call even while moving between cells. A user sets up a call thorough the cellular mobile communication system using a mobile station (MS) 30 capable of wirelessly communicating with the base stations 20, 21 and 22, to perform a voice call or data communication with another mobile station. A procedure for setting up an outgoing call in a cellular mobile communication system will now be described.

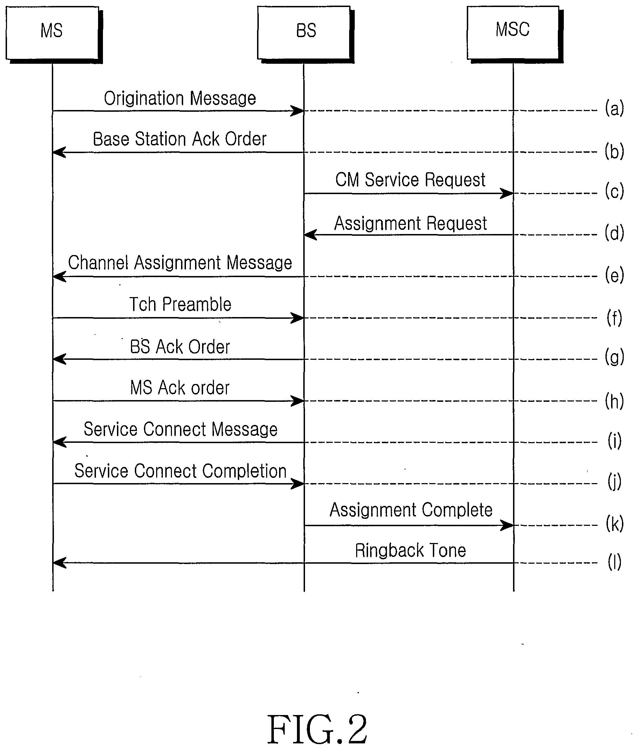

FIG. 2 is a message flow diagram illustrating a procedure for setting up an outgoing call according to the prior art. Referring to FIG. 2, in step (a), a mobile station transmits to a base station an Origination message containing a phone number of a desired recipient (or called party). Then the base station responds thereto by sending to the MS a base station acknowledgement order (BS Ack Order) in step (b), and sends to a mobile switching center a Configuration Module (CM) Service Request message in step (c). Upon receiving the CM Service Request message, the mobile switching center assigns resources for the mobile station that transmitted the Origination message, and sends to the base station in step (d) an Assignment Request message in order to request resource assignment in a wireless section (or wireless link).

In response to the Assignment Request message, the base station assigns a traffic channel over which it will communicate with the mobile station, and transmits to the mobile station in step (e) a Channel Assignment message. Upon receiving the Channel Assignment message, the mobile station sets up a traffic channel according to the received Channel Assignment message. After setting up a traffic channel, the mobile station transmits to the base station in step (f) a preamble (Tch Preamble) over the assigned traffic channel. When the preamble is successfully received, the base station transmits to the mobile station a BS Ack Order in step (g). In answer to the BS Ack Order, the mobile station transmits to the base station a mobile station acknowledgement order (MS Ack Order) in step (h).

After exchange of the Ack Orders, the mobile station exchanges with the base station a Service Connect message and a Service Connect Completion message in steps (i) and (j), for service negotiation. When the service negotiation is completed, the base station sends to the mobile switching center an Assignment Complete message in step (k), completing a call setup procedure requested by a calling party. Then the mobile switching center transmits to the mobile station in step (1) a ring back tone (RBT) via the base station until a response from a called party is received.

In such a conventional call setup procedure, commonly, 5 seconds are required for the mobile switching center to complete the resource assignment after receiving a CM Service Request message from the base station, and thereafter, 5 additional seconds are required for assignment of the wireless resources to the mobile station by the base station. The time delay caused by such a call setup procedure inconveniences users.

US 5 940 515 teaches a cellular telephonic communication system with privacy in the transmission of a dialed number from a mobile station to a base station. First a modified origination message without the calling number is transmitted from the calling station to the base station. Once the two-way communication between the calling station and the base station has commenced, the dialed number is transmitted via the reverse traffic channel from the calling station to the base station.

US 6 424 835 B1 teaches a method for controlling a call in a communication system, wherein en-bloc address signaling is replaced by overlap address signaling. En-bloc address signaling is not convenient in that the user must wait for the call set-up. As a remedy, US 6 424 835 B1 suggests initiating the set-up of a radio traffic channel between the mobile station and the base station upon input of a first digit in the mobile station. Digits input by the user's dialing during the traffic channel set-up are stored in the memory of the mobile station. Upon completion of the traffic channel set-up, a message comprising the digits stored in the memory, not necessarily the complete recipient's phone number, is sent to the base station.

### SUMMARY OF THE INVENTION

It is, therefore, an object of the present invention to provide a method for immediately performing resource assignment by a base station upon start of dial input and performing resource assignment by a mobile switching center after completion of the dial input in a call setup procedure.

It is another object of the present invention to provide a method for simultaneously performing resource assignment by a mobile switching center and resource assignment by a base station in a call setup procedure.

It is further another object of the present invention to provide a method for simultaneously performing resource assignment by a mobile switching center and immediate resource assignment by a base station upon start of dial input.

In accordance with one aspect of the present invention, there is provided a method for performing call setup in a mobile communication system including a base station for serving a mobile station in a service area thereof, and a mobile switching center for controlling the base station. The method comprising the steps of: upon receiving a recipient's phone number, transmitting by the mobile station an origination message to the base station; responding, by the base station, to the origination message from the mobile station, and setting up wireless channels to the mobile station; transmitting, by the mobile station, an origination continuation message to the base station, if setup of the wireless channels is completed and receiving of the recipient's phone number is completed; and upon receiving the origination continuation message, requesting by the base station the mobile switching center to perform call setup in a wired section.

In accordance with another aspect of the present invention, there is provided a method for performing call setup in a mobile communication system including a base station for serving a mobile station in a service area thereof, and a mobile switching center for controlling the base station. The method comprising the steps of: transmitting, by the mobile station, an origination message to the base station, if an outgoing call is needed; and upon receiving the origination message, transmitting by the base station a service request message for the mobile station to the mobile switching center, setting up wireless channels to the mobile station and performing service negotiation with the mobile station.

In accordance with further another aspect of the present invention, there is provided a method for performing call setup in a mobile communication system including a base station for serving a mobile station in a service area thereof, and a mobile switching center for controlling the base station. The method comprising the steps of: upon receiving a recipient's phone number, transmitting by the mobile station an origination message to the base station; upon receiving the origination message from the mobile station, transmitting by the base station a service request message to the mobile switching center and, at the same time, setting up wireless channels to the mobile station; upon completion of receiving the recipient's phone number, transmitting by the mobile station the recipient's phone number to the base station along with an origination continuation message; and upon receiving the origination continuation message, transmitting by the base station the recipient's phone number to the mobile switching center.

### BRIEF DESCRIPTION OF THE DRAWINGS

The above and other objects, features and advantages of the present invention will become more apparent from the following detailed description when taken in conjunction with the accompanying drawings in which:
FIG. 1 is a diagram illustrating a configuration of a typical cellular mobile communication system;
FIG. 2 is a message flow diagram illustrating a procedure for setting up an outgoing call according to the prior art;
FIG. 3 is a message flow diagram illustrating a call setup procedure according to a first embodiment of the present invention;
FIG. 4 is a flowchart illustrating an operation of a mobile station according to a first embodiment of the present invention;
FIG. 5 is a flowchart illustrating an operation of a base station according to a first embodiment of the present invention;
FIG. 6 is a message flow diagram illustrating a call setup procedure according to a second embodiment of the present invention;
FIG. 7 is a flowchart illustrating an operation of a mobile station according to a second embodiment of the present invention;
FIG. 8 is a flowchart illustrating an operation of a base station according to a second embodiment of the present invention;
FIG. 9 is a message flow diagram illustrating a call setup procedure according to a third embodiment of the present invention;
FIG. 10 is a flowchart illustrating an operation of a mobile station according to a third embodiment of the present invention;
FIG. 11 is a flowchart illustrating an operation of a base station according to a third embodiment of the present invention; and
FIG. 12 is a block diagram illustrating a structure of a mobile station according to another embodiment of the present invention.

### DETAILED DESCRIPTION OF THE PREFERRED EMBODIMENT

Several preferred embodiments of the present invention will now be described in detail with reference to the annexed drawings. In the following description, a detailed description of known functions and configurations incorporated herein has been omitted for conciseness.

The present invention provides an apparatus and method for setting up a transmission channel during the dialing procedure in a mobile communication system. The apparatus and method proposed herein allocates a transmission channel from a base station (BS) to a mobile switching center (MSC) immediately after completion of the dialing procedure.

### First Embodiment

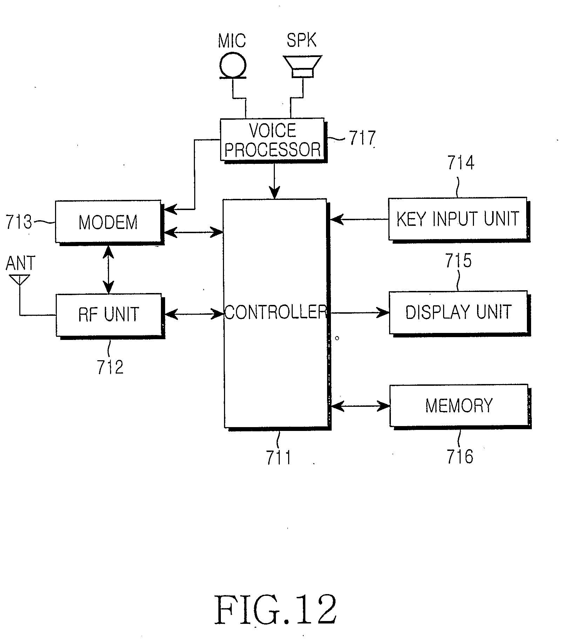

A first embodiment of the present invention performs call setup by a base station at the time when a user begins to input a phone number of a recipient with whom he or she desires to talk, i.e., before dial input is completed, and performs call setup by a mobile switching center the input of the phone number of the recipient is completed. An operation according to the first embodiment of the present invention will be described without consideration of speed dialing (or abbreviated dialing), which will be described with reference to FIG. 12.

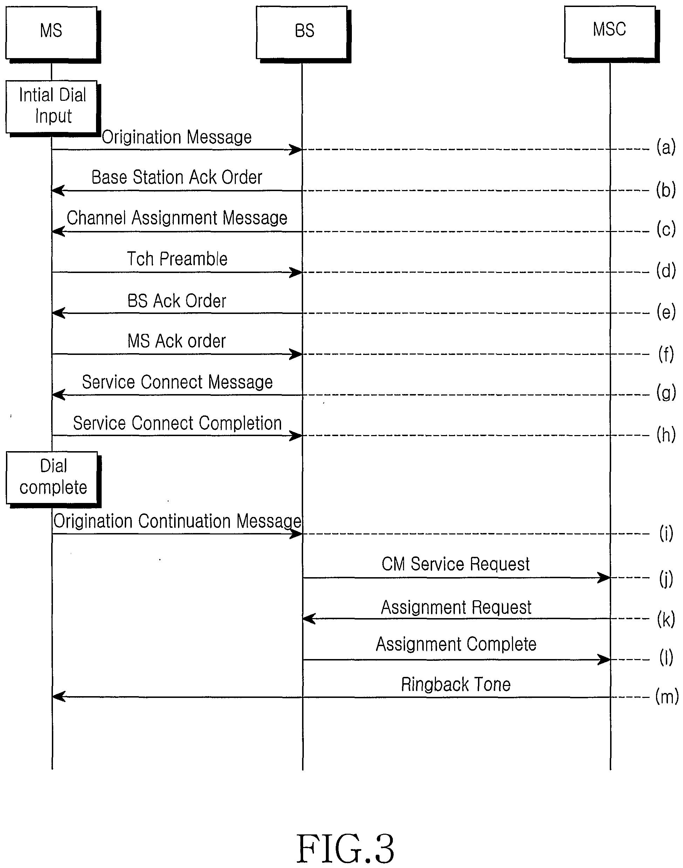

FIG. 3 is a message flow diagram illustrating a call setup procedure according to a first embodiment of the present invention. Referring to FIG. 3, when a user begins to input a phone number of a desired recipient, the mobile station transmits to a base station an Origination message in step (a). The Origination message transmitted at this step does not include a phone number of the recipient, but caninclude a dummy phone number comprised of '0s'. Then the base station responds thereto by sending to the mobile station a base station acknowledgement order (BS Ack Order) in step (b), and assigns a forward traffic channel and a corresponding reverse traffic channel without a wireless resource assignment request from a mobile switching center. The base station is designed such that it can perform an operation according to an embodiment of the present invention when it receives an Origination message not including a phone number of a recipient or including a dummy phone number consisting of '0s'. However, the base station can be designed such that it can perform the operation according to this embodiment of the present invention even when it receives an existing Origination message. In step (c), the base station immediately transmits to the mobile station a Channel Assignment message containing information on the assigned traffic channels. The base station has not yet sent a Configuration Module (CM) Service Request message to the mobile switching center.

Upon receiving the Channel Assignment message, the mobile station sets up a forward traffic channel and an associated reverse traffic channel according to the received Channel Assignment message. Thereafter, the mobile station transmits to the base station in step (d) a preamble (Tch Preamble) over the reverse traffic channel assigned by the base station. When the preamble is successfully received, the base station transmits to the mobile station a BS Ack Order in step (e), and in response, the mobile station transmits to the base station a mobile station acknowledgement order (MS Ack Order) in step (f). After completing setup of traffic channels in a wireless section (or wireless link) through exchange of the Ack Orders, the mobile station and the base station exchange a Service Connect message and a Service Connect Completion message in steps (g) and (h), thereby performing service negotiation for the traffic channels.

The call setup in a wireless section up to the service negotiation is generally completed before the user fully inputs a phone number of the recipient. Thereafter, when the user presses a Send button after completing input (or dialing) of the phone number of the recipient, the mobile station immediately transmits to the base station an Origination Continuation message containing the input recipient's phone number in step (i). Then the base station transmits to the mobile switching center a CM Service Request message in step (j).

If the call setup in a wireless section has not completed at the point when the Origination Continuation message is received, the base station transmits to the mobile switching center the CM Service Request message after completing the call setup in a wireless section.

The mobile switching center assigns wired resources in response to the CM Service Request message, and then transmits to the base station in step (k) an Assignment Request message to request assignment of a wireless resource. However, in the embodiment of the present invention, the base station has already assigned wireless resources to the mobile station. Therefore, the base station can regard the Assignment Request message as a message indicting that resource assignment by the mobile switching center is completed. Then, in step (1), the base station immediately transmits to the mobile switching center an Assignment Complete message in response to the Assignment Request message, completing the call setup procedure with the calling party. In step (m), the mobile switching center transmits to the mobile station a ring back tone (RBT) via the base station until a response from a called party is received.

According to the first embodiment of the present invention, a mobile station performs the call setup operation in a wireless section when a user inputs an initial button before pushing a Send button of the mobile station, or when the user desires to perform dialing while satisfying a predetermined condition. Upon receiving an Assignment Request message from a mobile switching center, a base station immediately transmits a response thereto, contributing to fast call setup. Such an operation can be equally performed even when speed dialing is performed. Even in a speed dialing mode, if a numeric key is input, the mobile station sends an Origination message, and the base station performs an operation equal to the operation described above. In addition, even in the speed dialing mode, the mobile station can transmit an Origination Continuation message containing a phone number in the same method as performed when the Send button is input. Specifically, if the last digit out of two or three-digit speed dial number is pressed for speed dialing, the mobile station reads a corresponding phone number from its memory. The mobile station can generate an Origination Continuation message using the read phone number as a recipient's phone number, and transmit to the base station the generated Origination Continuation message. In this way, the mobile station can immediately send an Origination message without waiting until the speed dial number is fully input. This will also be applied to other embodiments of the present invention.

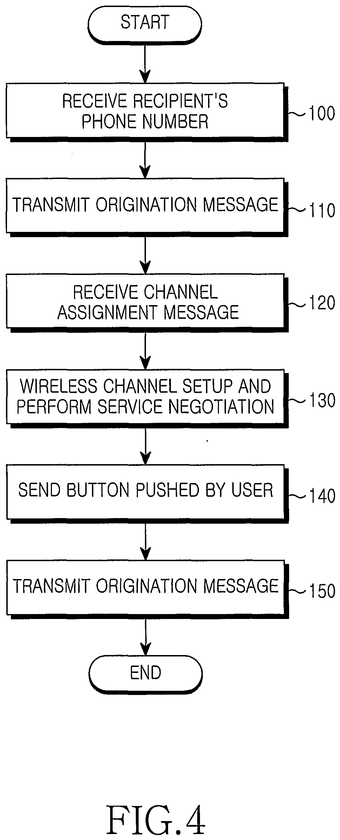

FIG. 4 is a flowchart illustrating an operation of a mobile station according to the first embodiment of the present invention. Referring to FIG. 4, if a recipient's phone number is input by a user in step 100, a mobile station immediately transmits to a base station an Origination message not including the recipient's phone number in step 110. As described in connection with FIG. 3, the mobile station can generate a dummy phone number consisting of '0s' and transmit the generated dummy phone number along with the Origination message. If a Channel Assignment message is received from the base station in response to the Origination message in step 120, the mobile station performs channel setup in a wireless section and service negotiation in step 130. That is, the mobile station sets up a channel in order to perform communication over a traffic channel previously assigned by the base station. Further, the mobile station transmits to the base station a preamble over a traffic channel set up by the base station. Thereafter, if a BS Ack Order is received from the base station, the mobile station performs service negotiation with the base station. After the service negotiation is completed, if the user has fully input the recipient's phone number and pushes a Send button in step 140, the mobile station transmits to the base station an Origination Continuation message containing the recipient's phone number in step 150.

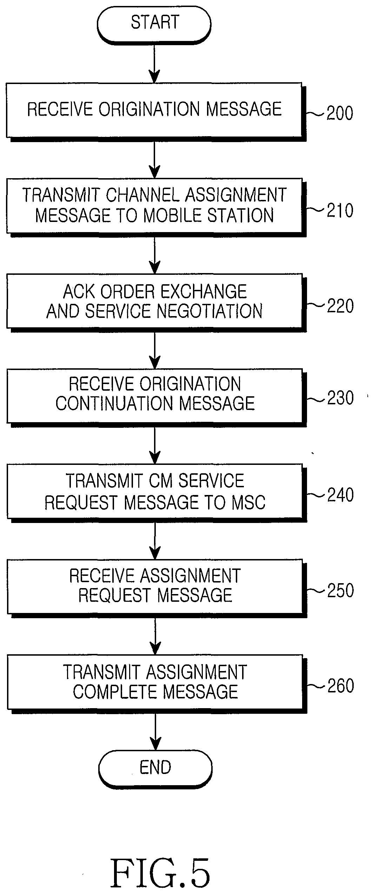

FIG. 5 is a flowchart illustrating an operation of a base station according to the first embodiment of the present invention. Referring to FIG. 5, in step 200, a base station receives from a mobile station an Origination message not including a recipient's phone number or including a dummy phone number consisting of '0s'. Then the base station assigns wireless resources for the mobile station, i.e., forward and reverse traffic channels, without sending to a mobile switching center, a CM Service Request message and transmits to the mobile station in step 210 a Channel Assignment message including assignment information of the forward and reverse traffic channels. In step 220, the base station performs Ack Order exchange and service negotiation. That is, the base station receives a preamble from the mobile station, and transmits to the mobile station a BS Ack Order in response to the preamble. Thereafter, the base station receives from the mobile station an MS Ack Order, and performs service negotiation. Thereafter, if an Origination Continuation message containing a recipient's phone number is received from the mobile station in step 230, the base station transmits to the mobile switching center in step 240 a CM Service Request message to perform call setup in a wired section (or wired link). Thereafter, if an Assignment Request message is received from the mobile switching center in step 250, the base station immediately transmits an Assignment Complete message to the mobile switching center in step 260.

### Second Embodiment

A second embodiment of the present invention performs call setup in a wireless section while an Origination message is received from a mobile station and call setup in a wired section is performed. An operation of the second embodiment can be performed when speed dialing is performed, or performed in a mobile station not supporting the first and third embodiments of the present invention.

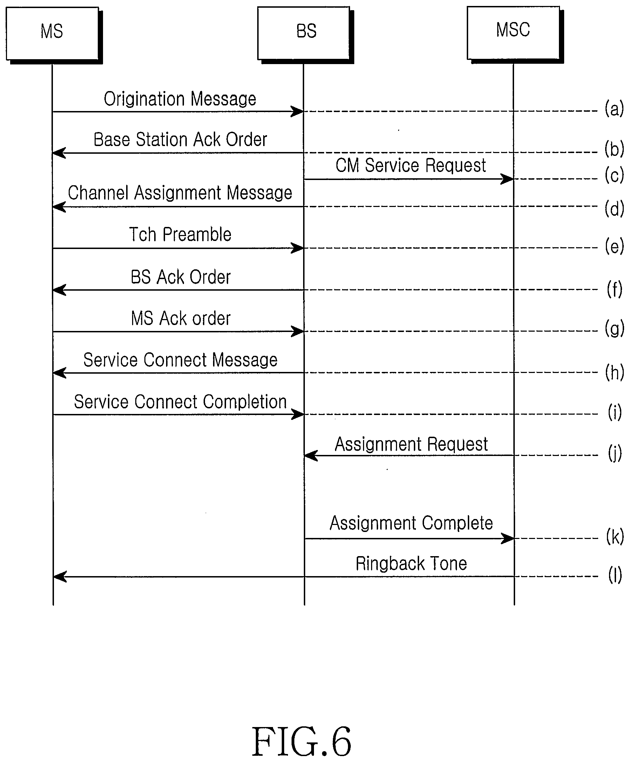

FIG. 6 is a message flow diagram illustrating a call setup procedure according to a second embodiment of the present invention. Referring to FIG. 6, a mobile station transmits to a base station in step (a) an Origination Message containing a recipient's phone number. Then the base station sends to the mobile station in step (b) a BS Ack Order in response to the Origination message, and transmits to a mobile switching center in step (c) a CM Service Request message to request the mobile switching center to assign a wired resource. Thereafter, the base station immediately assigns resources in a wireless section, i.e., a forward traffic channel and its associated reverse traffic channel, without receiving an Assignment Request message from the mobile switching center. Thereafter, the base station transmits to the mobile station in step (d) a Channel Assignment message containing the assignment information. In this manner, resource assignment for wired section by the mobile switching center and resource assignment for wireless section by the base station are simultaneously performed.

Upon receiving the Channel Assignment message, the mobile station sets up a forward traffic channel and its associated reverse traffic channel according to the received Channel Assignment message. In step (e), the mobile station transmits to the mobile station a preamble (Tch Preamble) over the reverse traffic channel assigned by the base station. Upon receiving the preamble from the mobile station, the base station transmits to the mobile station a BS Ack Order in step (f), and in response, the mobile station transmits to the base station an MS Ack Order in step (g).

After completing setup of wireless traffic channels through exchange of the Ack Orders, the mobile station and the base station exchange a Service Connect message and a Service Connect Completion message in steps (h) and (i), thereby performing service negotiation. After the call setup in a wireless section up to the service negotiation is completed, the mobile switching center transmits to the base station an Assignment Request message in step (j). At this point, because the base station has already assigned or is assigning channels to the mobile station, it regards the Assignment Request message received from the mobile switching center as a message indicting that call setup in a wired section is completed. Therefore, the base station immediately transmits to the mobile switching center an Assignment Complete message in step (k), completing the call setup of the calling party. Unlike that shown in FIG. 6, the Assignment Request message can also be transmitted before the call setup in a wireless section is completed. After completing the call setup in a wireless section, the base station transmits to the mobile switching center an Assignment Complete message. After the Assignment Complete message is received. at the mobile switching center, i.e., if call setup at a calling party is completed, the mobile switching center transmits to the mobile station a ring back tone via the base station in step (1).

In the second embodiment of the present invention, call setup in a wireless section and call setup in a wired section are simultaneously performed, minimizing a time delay during the call setup procedure.

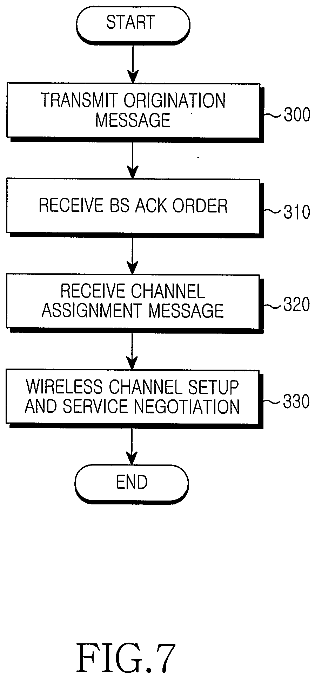

FIG. 7 is a flowchart illustrating an operation of a mobile station according to a second embodiment of the present invention. Referring to FIG. 7, a mobile station transmits to a base station an Origination message containing a phone number of a desired recipient in step 300, and receives a BS Ack Order from the base station in step 310. Thereafter, the mobile station receives from the base station a Channel Assignment message containing assignment information of wireless channels in step 320, and performs wireless channel setup and service negotiation according to the assignment information in step 330. That is, the mobile station sets up a forward traffic channel and its associated reverse traffic channel. Thereafter, the mobile station transmits to the base station a preamble over the reverse traffic channel assigned by the base station, exchanges Ack Orders with the base station, and performs service negotiation.

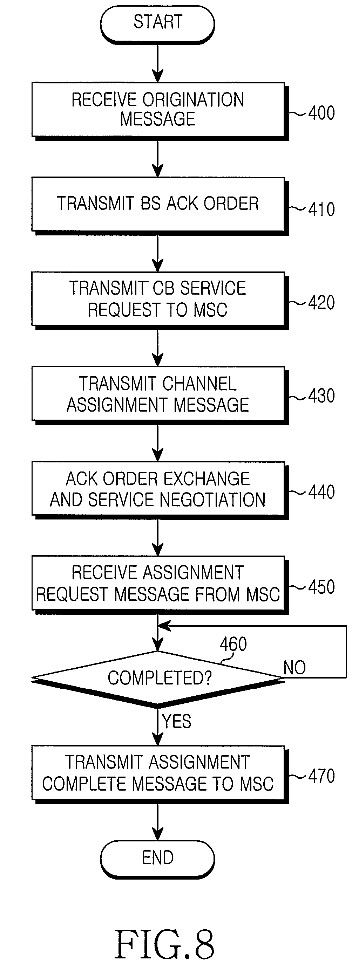

FIG. 8 is a flowchart illustrating an operation of a base station according to the second embodiment of the present invention. Referring to FIG. 8, a base station receives from a mobile station an Origination message containing a recipient's phone number in step 400, and transmits to the mobile station a BS Ack Order in step 410. Thereafter, in step 420, the base station transmits to a mobile switching center a CM Service Request message. Thereafter, the base station immediately assigns wireless resources, i.e., a forward traffic channel and its associated reverse traffic channel, without receiving from the mobile switching center, an Assignment Request message and then transmits to the mobile station in step 430 a Channel Assignment message containing the assignment information.

In step 440, the base station performs Ack Order exchange and service negotiation in step 440. That is, the base station receives a preamble from the mobile station over the assigned reverse traffic channel. Thereafter, the base station exchanges Ack Orders with the mobile station, and performs service negotiation. If an Assignment Request message is received from the mobile switching center in step 450, the base station determines in step 460 whether setup of wireless channels is completed. If it is determined that setup of wireless channels is completed, the base station transmits to the mobile switching center an Assignment Complete message in step 470. However, if it is determined in step 460 that setup of wireless channels is not completed, the base station waits until setup of the wireless channels is completed before transmitting to the mobile switching center the Assignment Complete message.

### Third Embodiment

In a third embodiment of the present invention, a base station and a mobile switching center simultaneously perform call setup at the time when a user begins to input a phone number of a desired recipient with whom he or she desires to talk. Like the first embodiment, the third embodiment will also be described without consideration of speed dialing, which will be described with reference to FIG. 12.

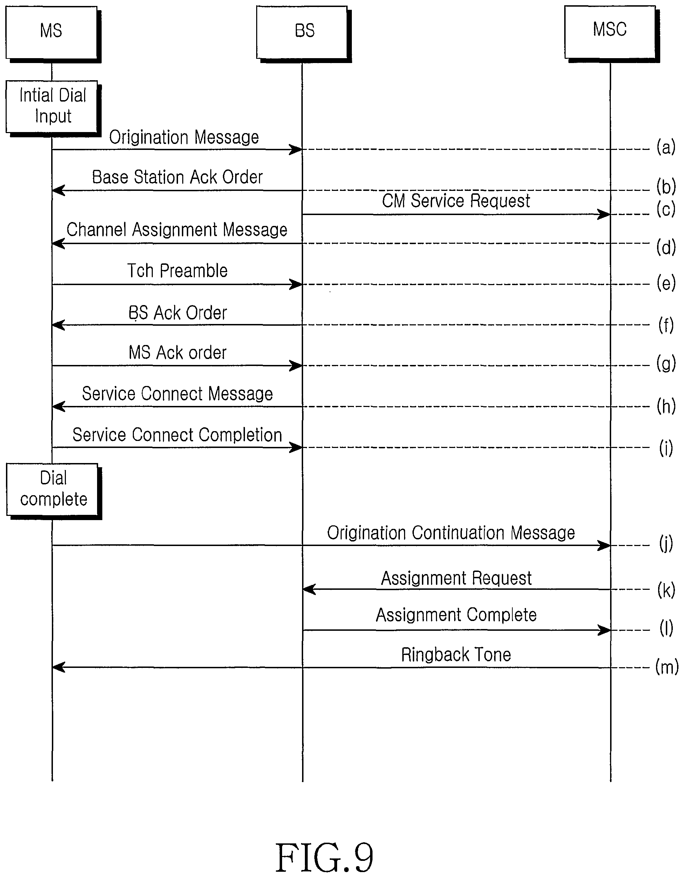

FIG. 9 is a message flow diagram illustrating a call setup procedure according to the third embodiment of the present invention. Referring to FIG. 9, when a user begins to dial a phone number of a desired recipient, the mobile station transmits an Origination message to a base station in step (a). In this case, the Origination message does not include a recipient's phone number, or includes a dummy phone number consisting of '0s'. Then the base station responds to the Origination message by sending to the mobile station a BS Ack Order in step (b), and transmits to a mobile switching center a CM Service Request message in step (c) in order to request the mobile switching center to perform necessary resource assignment in a wired section.

At the same time, the base station assigns a forward traffic channel and its associated reverse traffic channel without receiving from the mobile switching center an Assignment Request message for wireless resources, and transmits to the mobile station in step (d) a Channel Assignment message containing the assignment information. The mobile station assigns a forward traffic channel and its associated reverse traffic channel according to the assignment information included in the Channel Assignment message, and transmits to the base station a preamble (Tch Preamble) over the assigned reverse traffic channel in step (e). Upon receiving the preamble, the base station transmits to the mobile station a BS Ack Order in step (f). In response to the BS Ack Order, the mobile station creates an MS Ack Order and transmits to the base station the MS Ack Order in step (g). After completing setup of traffic channels in a wireless section through exchange of the Ack Orders, the mobile station and the base station exchange a Service Connect message and a Service Connect Completion message in steps (h) and (i), thereby performing service negotiation.

Thereafter, if the user pushes a Send button after completing input (or dialing) of a recipient's phone number, the mobile station immediately transmits to the base station in step (j) an Origination Continuation message containing the recipient's phone number and the base station then transfers to the mobile switching center the recipient's phone number. Independently, the mobile switching center transmits to the base station an Assignment Request message in step (k), when it completes resource assignment in a wired section. Optionally, the Assignment Request message can be transmitted to the base station before the time shown in FIG. 9. That is, the mobile switching center can transmit to the base station the Assignment Request message as soon as the mobile switching center completes resource assignment in a wired section. Therefore, if call setup in a wireless section has been completed at the time when the Assignment Request message is received, the base station immediately transmits to the mobile switching center an Assignment Complete message in step (1). However, if call setup in a wireless section has not completed, the base station sends to the mobile switching center an Assignment Complete message after completing the call setup in a wireless section. In this embodiment, the base station has already performed assignment of wireless resources before the Assignment Request message is received. Therefore, since preparation for call setup in a wired section is completed, the Assignment Complete message can be used as a message indicating that a procedure for call setup for the calling party is completed. In addition, the Assignment Request message can be used as a message indicating completed assignment of wired resources.

In the third embodiment of the present invention, call setup in a wireless section and call setup in a wired section are simultaneously performed before input of recipient's phone number is completed, thereby contributing to fast call setup.

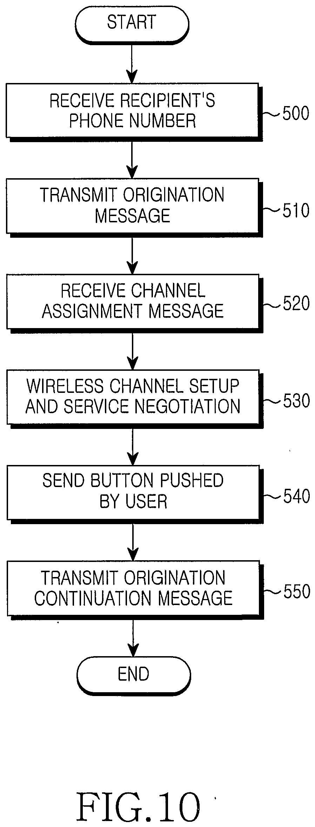

FIG. 10 is a flowchart illustrating an operation of a mobile station according to the third embodiment of the present invention. Referring to FIG. 10, if a user begins to input a recipient's phone number in step 500, a mobile station immediately transmits to a base station an Origination message not containing a recipient's phone number in step 510. The Origination message, as stated in connection with FIG. 9, can include a dummy phone number consisting of '0s'. If a Channel Assignment message is received from the base station in step 520, the mobile station performs channel setup in a wireless section and service negotiation in step 530. That is, the mobile station sets up a traffic channel according to the received Channel Assignment message, and transmits to the base station a preamble over the assigned traffic channel. Thereafter, the mobile station performs service negotiation upon receiving a BS Ack Order. If the user presses a Send button after completing input of a recipient's phone number in step 540, the mobile station transmits to the base station an Origination Continuation message containing the recipient's phone number in step 550.

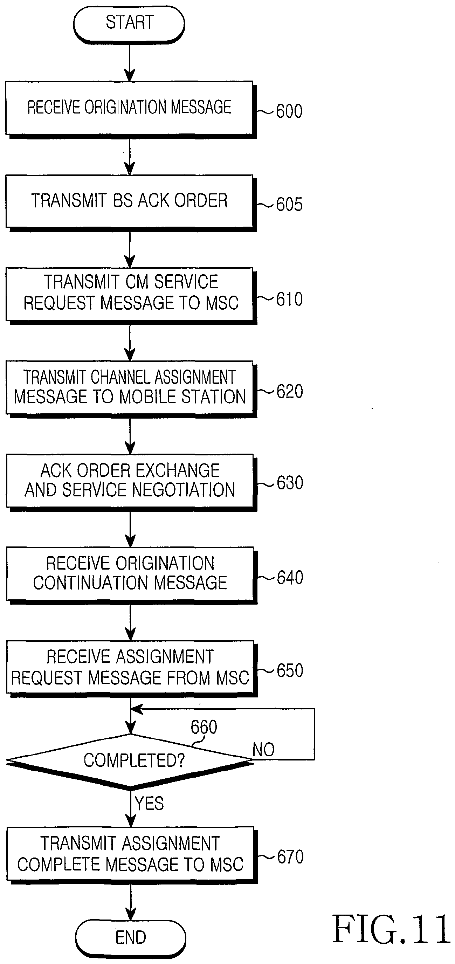

FIG. 11 is a flowchart illustrating an operation of a base station according to the third embodiment of the present invention. Referring to FIG. 11, if an Origination message that does not contain a recipient's phone number or an Origination message that contains a dummy phone number consisting of '0s' is received from a mobile station in step 600, a base station generates a BS Ack Order message and transmits to the mobile station the BS Ack Order in step 605. In step 610, the base station transmits to a mobile switching center a CM Service Request message. Thereafter, in step 620, the base station assigns wireless resources, i.e., forward and reverse traffic channels, for the mobile station, and transmits to the mobile station a Channel Assignment message containing the assignment information. In step 630, the base station performs service negotiation after Ack Order exchange with the mobile station through the assigned wireless channels. Specifically, the base station transmits to the mobile station a BS Ack Order upon receiving from the mobile station, a preamble and then receives from the mobile station an MS Ack Order. After exchange of the Ack Orders, the base station performs service negotiation with the mobile station. In step 640, the base station receives from the mobile station an Origination Continuation message and transmits to the mobile switching center the received Origination Continuation message. Thereafter, if an Assignment Request message is received from the mobile switching center in step 650, the base station determines in step 660 whether call setup in a wireless section is completed. If the call setup in a wireless section is completed, the base station transmits to the mobile switching center an Assignment Complete message in step 670. Otherwise, the base station waits until the call setup in a wireless section is completed to transmit the Assignment Complete message.

FIG. 12 is a block diagram illustrating a structure of a mobile station according to an embodiment of the present invention. An operation of a mobile station according to an embodiment of the present invention will now be described in detail with reference to FIG. 12.

A radio frequency (RF) unit 712, under the control of a controller 711, sets up reverse and forward channels, down-converts a message or data received over a forward channel into a baseband signal, and provides the baseband signal to a modem 713. Further, the RF unit 712 up-converts data received from the modem 713 and transmits the up-converted data to a base station over a reverse channel. The modem 713 demodulates data received from the RF unit 712, and provides the demodulated data to the controller 711. Further, the modem 713 encodes and modulates a message or data received from the controller 711 and data received from a voice processor 717, and provides its output to the RF unit 712. Further, when the modem 713 receives a voice signal, the modem 713 converts the received voice signal into an electrical voice signal and outputs the electrical voice signal to a speaker. And, when the modem 713 receives an electrical voice signal from a microphone, the modem 713 modulates the received electrical voice signal and outputs the modulated signal to the RF unit 712. The voice processor 717 provides voice data to the modem 713 under the control of the controller 711. A key input unit 714 can be comprised of alphanumeric keys for dialing and function keys for setting various functions. Alternatively, the key input unit 714 can be comprised of a touch pad not having physical keys. The key input unit 714 generates a key signal corresponding to a key input by a user, and provides the key signal to the controller 711. A display unit 715 can be comprised of a part for providing a graphic user interface (GUI) to the user, and a part for providing an alarm to the user. The part for providing GUI can be generally comprised of a liquid crystal display (LCD), and the part for providing an alarm can be comprised of an alarm lamp or a light emitting diode (LED). A memory 716 stores a control program according to an embodiment of the present invention, and data generated during execution of the control program. In addition, the memory 716 stores phone numbers for speed dialing in association with their speed dial numbers. Further, a select bit for enabling or disabling an operation proposed in an embodiment of the present invention can be additionally provided. In this case, the select bit is also stored in the memory 716. An operation performed when such a select bit is used will now be described herein below.

It will be assumed that the mobile station operates based on one of the first to third embodiments of the present invention. The mobile station can be designed such that one of the operations based on the embodiments can be set during manufacturing process or selected at the discretion of a user. Herein, it will be assumed that one of the three embodiments is set during manufacturing of the mobile station. In this case, if the select bit is set, the mobile station performs a call setup procedure corresponding to one of the first to third embodiments of the present invention. Such a control operation of the controller 711 will now be described herein below.

When an initial key for dialing is input from the key input unit 714, the controller 711 generates an Origination message and outputs the Origination message to the modem 713. As stated above, the Origination message does not include a recipient's phone number, or includes a dummy phone number consisting of '0s'. If the controller 711 operates in a method proposed by the second embodiment, the controller 711 generates the Origination message after dialing is fully completed or when speed dialing is performed. In this case, the controller 711 does not perform the method of generating an Origination message not including recipient's phone number or including a dummy phone number. Even in the first and third embodiments, in a speed dialing mode, the controller 711 can generate an Origination message when a predetermined number of keys are input. For example, if the number of digits allocated for speed dialing is 2, i.e., if unique numbers of '00' to '99' are allocated for speed dialing, the controller 711 performs the first and third embodiments when a third digit is input. In addition, if the number of digits allocated for speed dialing is 3, i.e., if unique numbers of '000' to '999' are allocated for speed dialing, the controller 711 performs the first and third embodiments when a fourth digit is input. Alternatively, the controller 711 can operate as described in the last section of the first embodiment. Specifically, when the select bit is set, if an initial key for dialing is input, the controller 711 generates an Origination message and transmits the Origination message. Thereafter, if speed dialing is requested, the controller 711 reads a phone number corresponding to the input speed dial number from the memory 716, and generates an Origination message using the read phone number as a recipient's phone number. In this case, the controller 711 can generate an Origination message without determining whether a speed dial number is input.

When the Origination message not containing a called party's phone number or containing a dummy phone number is input to the modem 713, the modem 713 encodes and modulates the Origination message and outputs the modulated Origination message to the RF unit 712, under the control of the controller 711. Then the RF unit 712 up-converts the modulated Origination message and transmits the up-converted Origination message over a reverse link. Thereafter, a BS Ack Order message and a Channel Assignment message are received via the RF unit 712, processed by the modem 713, and then provided to the controller 711. Then the controller 711 performs a control operation of setting up forward and reverse traffic channels according to the Channel Assignment message. Specifically, the controller 711 controls the RF unit 712 so that it can receive traffic over the assigned forward traffic channel and transmit data over the assigned reverse traffic channel. Thereafter, the controller 711 transmits a preamble over the assigned reverse traffic channel. Subsequently, the controller 711 exchanges Ack Order messages with the base station, and performs service negotiation with the base station. Such an operation is equal to the conventional operation, so a detailed description thereof will not be given.

The controller 711 determines whether a dial complete signal is received from the key input unit 714. The "dial complete signal" can represent a signal generated when a Send key prepared in the key input unit 714 is pressed. However, in a speed dialing mode, the "dial complete signal" represents a signal generated when a speed dial number is input. For example, if the number of digits constituting a speed dial number is 2, the dial complete signal represents a signal generated when a second digit is pushed long. Alternatively, if the number of digits constituting a speed dial number is 3, the dial complete signal represents a signal generated when a third digit is depressed long. If such a Send signal is received, the controller 711 performs a control operation of generating an Origination Continuation message and transmitting the Origination Continuation message to the base station. In this control operation, the controller 711 generates an Origination Continuation message including an entire called party's phone number and provides the Origination Continuation message to the modem 713, the modem 713 performs encoding and modulation on the Origination Continuation message, and the RF unit 712 up-converts the modulated Origination Continuation message and transmits the up-converted Origination Continuation message to the base station. The following call setup operation is equal to the conventional one. The dial complete signal is not related to the second embodiment.

As can be appreciated from the foregoing description, the present invention immediately sets up wireless channels at the begining of dial input in a call setup procedure in a mobile communication system. After completion of the dial input, a base station attempts call setup to a mobile switching center, or the base station and the mobile switching center simultaneously perform the call setup procedure. In this manner, it is possible to prevent a time delay caused by the call setup procedure, minimizing inconveniences to the user.

While the invention has been shown and described with reference to a certain preferred embodiment thereof, it will be understood by those skilled in the art that various changes in form and details may be made therein without departing from the scope of the invention as defined by the appended claims.

## Claims

1. A method for performing call setup by a mobile station (30) in a mobile communication system having a base station (20, 21, 22) for serving the mobile station (30), and a mobile switching center (10) for controlling the base station (20, 21, 22), the method comprising the steps of:
when an initial key for dialing is input, transmitting (110) to the base station (20, 21, 22) an origination message that does not contain the recipient's phone number;
upon receiving (120) a channel assignment message from the base station (20, 21, 22), setting (130) up wireless channels to the base station (20, 21, 22) according to assignment information included in the channel assignment message; and
upon completion of entry of the recipient's phone number, transmitting (150) to the base station (20, 21, 22) an origination continuation message containing the recipient's phone number;
**characterized in that**
the base station (20, 21, 22) transmits to a mobile switching center (10) a service request message requesting assignment of a wired resource upon reception of the origination message from the mobile station (30) and simultaneously assigns wireless resources to the mobile station (30),
wherein the base station (20, 21, 22) performs the assignment of the wireless resources, and the mobile switching center (10) performs the assignment of the wired resource.

2. The method of claim 1, wherein the step of setting up wireless channels comprises the steps of:
assigning a forward traffic channel and a reverse traffic channel corresponding thereto according to the assignment information, and transmitting a preamble over the assigned reverse traffic channel; and
exchanging acknowledgement, Ack, orders with the base station (20, 21, 22) and performing service negotiation with the base station (20, 21, 22).

3. The method of claim 1, wherein the origination message includes a dummy phone number consisting of all '0s'.

4. The method of claim 1, further comprising the steps of:
upon receiving an origination message that does not contain the recipient's phone number from the mobile station (30), transmitting to the mobile station (30) the channel assignment message containing the assignment information;
after transmitting the channel assignment message, assigning wireless channels to the mobile station (30); and
upon receiving an assignment request message from the mobile switching center (10), transmitting an assignment complete message to the mobile switching center (10).

5. The method of claim 4, further comprising the steps of:
upon receiving the assignment request message from the mobile switching center (10), determining whether assignment of the wireless channels is completed; and
transmitting the assignment complete message to the mobile switching center (10) if assignment of the wireless channels is completed.

6. A mobile station apparatus for performing call setup in a mobile communication system, comprising:
a key input unit (714) for generating a key signal corresponding to a key input by a user;
a radio frequency, RF, unit (712) for up-converting a signal to be transmitted to a base station (20, 21, 22) into an RF signal, and down-converting an RF signal received from the base station (20, 21, 22) into a baseband signal;
a modem (713) for encoding and modulating data or a message to be transmitted to the base station (20, 21, 22), providing the modulated data or message to the RF unit (712), and demodulating and decoding the baseband signal received from the RF unit (712); and
a controller (711) for generating (110) an origination message that does not contain a recipient's phone number and providing the origination message to the modem (713) when an initial key for dialing is input from the key input unit (714), controlling the RF unit (712) to set (130) up wireless channels and performing service negotiation upon receiving (120) a channel assignment message, and generating (150) an origination continuation message containing the recipient's phone number and providing the origination continuation message to the modem (713) when a key input complete signal is received from the key input unit (714),
**characterized in that**
the base station (20, 21, 22) transmits to a mobile switching center (10) a service request message requesting assignment of a wired resource upon reception of the origination message from the mobile station (30) and simultaneously assigns wireless resources to the mobile station apparatus (30),
wherein the base station (20, 21, 22) performs the assignment of the wireless resources, and the mobile switching center (10) performs the assignment of the wired resource.

7. The apparatus of claim 6, wherein the controller (711) is configured to assign a forward traffic channel and a reverse traffic channel corresponding thereto according to the assignment information, and transmit a preamble over the assigned reverse traffic channel, exchanging acknowledgement, Ack, orders with the base station (20, 21, 22) and performing service negotiation with the base station (20, 21, 22).

8. The apparatus of claim 6, wherein the origination message includes a dummy phone number consisting of all '0s'.

## Patentansprüche

1. Verfahren für die Ausführung eines Verbindungsaufbaus durch eine Mobilstation (30) in einem mobilen Kommunikationssystem, das eine Basisstation (20, 21, 22), die die Mobilstation (30) versorgt, und ein mobiles Schaltzentrum (10) umfasst, um die Basisstation (20, 21, 22) zu steuern, wobei das Verfahren folgende Schritte umfasst:
wenn ein anfänglicher Schlüssel zum Wählen eingegeben wurde, Senden (110) einer Ursprungsnachricht, die die Telefonnummer des Empfängers nicht enthält, zu der Basisstation (20, 21, 22);
bei Empfang (120) einer Kanalzuordnungsnachricht von der Basisstation (20, 21, 22), Einrichten (130) von drahtlosen Kanälen zu der Basisstation (20, 21, 22) gemäß Zuordnungsinformationen, die in der Kanalzuordnungsnachricht enthalten sind; und
bei Vervollständigung des Eintrags der Telefonnummer des Empfängers, Senden (150) einer Ursprungsfortführungsnachricht, die die Telefonnummer des Empfängers umfasst, zu der Basisstation (20, 21, 22):
**dadurch gekennzeichnet, dass**
die Basisstation (20, 21, 22) zu einem mobilen Schaltzentrum (10) eine Diensteanforderungsnachricht sendet, die eine Zuordnung einer drahtgebundenen Ressource bei Empfang der Ursprungsnachricht von der Mobilstation (30) anfordert und gleichzeitig drahtlose Ressourcen der Mobilstation (30) zuordnet,
wobei die Basisstation (20, 21, 22) die Zuordnung der drahtlosen Ressourcen ausführt und das mobile Schaltzentrum (10) die Zuordnung der drahtgebundenen Ressourcen ausführt.

2. Verfahren nach Anspruch 1, bei dem der Schritt des Einrichtens folgende Schritte umfasst:
Zuordnen eines vorwärts gerichteten Verkehrskanals und eines rückwärts gerichteten Verkehrskanals, der diesem entspricht, gemäß den Zuordnungsinformationen und Senden einer Präambel über den zugeordneten rückwärts gerichteten Verkehrskanal; und
Austauschen von Bestätigungs-, Ack-, Befehlen mit der Basisstation (20, 21, 22) und Ausführen einer Diensteverhandlung mit der Basisstation (20, 21, 22).

3. Verfahren nach Anspruch 1, bei dem die Ursprungsnachricht eine Dummy-Telefonnummer umfasst, die vollstädig aus "0en" besteht.

4. Verfahren nach Anspruch 1, weiterhin umfassend folgende Schritte:
bei Empfang einer Ursprungsnachricht, die nicht die Telefonnummer des Empfängers umfasst, von der Mobilstation (30), Senden der Kanalzuordnungsnachricht, die die Zuordnungsinformationen umfasst, zu der Mobilstation;
nach dem Senden der Kanalzuordnungsnachricht, Zuordnen von drahtlosen Kanälen zu der Mobilstation (30); und
bei Empfang einer Zuordnungsanforderungsnachricht von dem mobilen Schaltzentrum (10), Senden einer Zuordnungsvervollständigungsnachricht zu dem mobilen Schaltzentrum (10).

5. Verfahren nach Anspruch 4, weiterhin umfassend folgende Schritte:
bei Empfang der Zuordnungsanforderungsnachricht von dem mobilen Schaltzentrum (10), Bestimmen, ob die Zuordnung der drahtlosen Kanäle abgeschlossen ist; und Senden der Zuordnungsvervollständigungsnachricht zu dem mobilen Schaltzentrum (10), sofern die Zuordnung der drahtlosen Kanäle abgeschlossen ist.

6. Mobilstationsgerät für die Ausführung eines Verbindungsaufbaus in einem mobilen Kommunikationssystem, umfassend:
eine Tasteneingabeeinheit (714) für die Erzeugung eines Tastensignals entsprechend einer Tasteneingabe durch einen Benutzer;
eine Hochfrequenz-, HF-, Einheit (712) für die Aufwärtskonvertierung eines Signals, das zu einer Basisstation (20, 21, 22) zu senden ist, in ein HF-Signal und Abwärtskonvertieren eines HF-Signals, das von der Basisstation (20, 21, 22) empfangen wird, in ein Basisbandsignal;
ein Modem (713) für das Codieren und Modulieren von Daten oder einer Nachricht, die zu der Basisstation (20, 21, 22) zu senden ist, das Bereitstellen der modulierten Daten oder der Nachricht für die HF-Einheit (712) und das Demodulieren und Decodieren des Basisbandsignals, das von der HF-Einheit (712) empfangen wird; und
eine Steuereinheit (711) für die Erzeugung (110) einer Ursprungsnachricht, die nicht eine Telefonnummer des Empfängers umfasst, und für die Bereitstellung der Ursprungsnachricht für das Moden (713), wenn eine Anfangstaste für das Wählen von der Tasteneingabeeinheit (714) eingegeben wird, für das Steuern der HF-Einheit (712) für die Einrichtung (130) der drahtlosen Kanäle und das Ausführen einer Diensteaushandlung bei Empfang (120) einer Kanalzuordnungsnachricht, und für das Erzeugen (150) einer Ursprungsfortführungsnachricht, die die Telefonnummer des Empfängers umfasst, und das Bereitstellen der Ursprungsfortführungsnachricht für das Modem (713), wenn ein Tasteneingabe-Vervollständigungssignal von der Tasteneingabeeinheit (714) empfangen wird,
**dadurch gekennzeichnet, dass**
die Basisstation (20, 21, 22) zu einem mobilen Schaltzentrum (10) eine Diensteanforderungsnachricht sendet, die eine Zuordnung einer drahtgebundenen Ressource bei Empfang der Ursprungsnachricht von der Mobilstation (30) anfordert und gleichzeitig drahtlose Ressourcen dem Mobilstationsgerät (30) zuordnet,
wobei die Basisstation (20, 21, 22) die Zuordnung der drahtlosen Ressourcen ausführt und das mobile Schaltzentrum (10) die Zuordnung der drahtgebundenen Ressourcen ausführt.

7. Gerät nach Anspruch 6, bei dem die Steuereinheit (711) dazu eingerichtet ist, einen vorwärts gerichteten Verkehrskanal und einen diesem entsprechenden rückwärts gerichteten Verkehrskanal gemäß den Zuordnungsinformationen zuzuordnen und eine Präambel über den zugeordneten rückwärts gerichteten Verkehrskanal zu senden, Bestätigungs-, Ack-, Befehle mit der Basisstation (20, 21, 22) auszutauschen und eine Diensteaushandlung mit der Basisstation (20, 21, 22) auszuführen.

8. Gerät nach Anspruch 6, bei dem die Ursprungsnachricht eine Dummy-Telefonnummer umfasst, die vollständig aus "0en" besteht.

## Revendications

1. Procédé permettant à une station mobile (30) d'effectuer un établissement de communication dans un système de communication mobile comportant une station de base (20, 21, 22) permettant de desservir la station mobile (30), ainsi qu'un central mobile (10) permettant de commander la station de base (20, 21, 22), le procédé comprenant les étapes suivantes :
la transmission (110) à la station de base (20, 21, 22), lorsqu'est saisie une clé initiale de composition, d'un message de départ qui ne contient pas le numéro de téléphone du destinataire,
l'établissement (130) de canaux sans fil vers la station de base (20, 21, 22), à la réception (120) d'un message d'assignation de canaux provenant de la station de base (20, 21, 22), en fonction d'informations d'assignation incluses dans le message d'assignation de canaux, et
la transmission (150) à la station de base (20, 21, 22) d'un message de poursuite d'origine contenant le numéro de téléphone du destinataire à l'achèvement de la saisie du numéro de téléphone du destinataire,
**caractérisé en ce que**
la station de base (20, 21, 22) transmet à un central mobile (10) un message de demande de service requérant l'assignation d'une ressource câblée à la réception du message d'origine provenant de la station mobile (30), et elle assigne simultanément des ressources sans fil à la station mobile (30),
la station de base (20, 21, 22) effectuant l'assignation des ressources sans fil et le central mobile (10) effectuant l'assignation de la ressource câblée.

2. Procédé selon la revendication 1, dans lequel l'étape d'établissement de canaux sans fil comprend les étapes suivantes :
l'assignation d'un canal de trafic direct et d'un canal de trafic inverse lui correspondant en fonction des informations d'assignation, et la transmission d'un préambule sur le canal de trafic inverse assigné, et
l'échange d'ordres d'accusé de réception, ACK, avec la station de base (20, 21, 22) et l'exécution d'une négociation de service avec la station de base (20, 21, 22).

3. Procédé selon la revendication 1, dans lequel le message d'origine inclut un numéro de téléphone fictif constitué uniquement de « 0 ».

4. Procédé selon la revendication 1, comprenant en outre les étapes suivantes :
la transmission à la station mobile (30) du message d'assignation de canaux contenant les informations d'assignation à la réception d'un message d'origine provenant de la station mobile (30), lequel ne contient pas le numéro de téléphone du destinataire,
l'assignation de canaux sans fil à la station mobile (30) après la transmission du message d'assignation de canaux, et
la transmission d'un message d'achèvement d'assignation au central mobile (10) à la réception d'un message de demande d'assignation provenant du central mobile (10).

5. Procédé selon la revendication 4, comprenant en outre les étapes suivantes :
la détermination de ce que l'assignation des canaux sans fil est achevée à la réception du message de demande d'assignation provenant du central mobile (10), et
la transmission du message d'achèvement d'assignation au central mobile (10) si l'assignation des canaux sans fil est achevée.

6. Appareil constituant une station mobile permettant d'effectuer un établissement de communication dans un système de communication mobile, comprenant :
une unité de saisie de clé (714) permettant de générer un signal de clé correspondant à une clé saisie par un utilisateur,
une unité radiofréquence, RF, (712) permettant de transposer en fréquence un signal à transmettre à une station de base (20, 21, 22) en un signal RF, et d'abaisser en fréquence un signal RF reçu en provenance de la station de base (20, 21, 22) en un signal en bande de base,
un modem (713) permettant de coder et de moduler des données ou un message à transmettre à la station de base (20, 21, 22), de délivrer les données ou le message modulé à l'unité RF (712), et de démoduler et de décoder le signal en bande de base reçu de l'unité RF (712), et
un contrôleur (100) permettant de générer un message d'origine qui ne contient pas le numéro de téléphone du destinataire et de fournir le message d'origine au modem (713) lorsqu'il est saisi une clé initiale de composition provenant de l'unité de saisie de clé (714), de commander l'unité RF (712) pour établir (130) des canaux sans fil et effectuer une négociation de service à la réception (120) d'un message d'assignation de canaux, ainsi que de générer (150) un message de poursuite d'origine contenant le numéro de téléphone du destinataire et délivrer le message de poursuite d'origine au modem (713) lorsqu'un signal de saisie de clé complet est reçu en provenance de l'unité de saisie de clé (714),
**caractérisé en ce que**
la station de base (20, 21, 22) transmet à un central mobile (10) un message de demande de service requérant l'assignation d'une ressource câblée à la réception du message d'origine provenant de la station mobile (30), et elle assigne simultanément des ressources sans fil à la station mobile (30),
la station de base (20, 21, 22) effectuant l'assignation des ressources sans fil et le central mobile (10) effectuant l'assignation de la ressource câblée.

7. Appareil selon la revendication 6, dans lequel le contrôleur (711) est configuré pour assigner un canal de trafic direct et un canal de trafic inverse lui correspondant en fonction des informations d'assignation, et pour transmettre un préambule sur le canal de trafic inverse assigné, en échangeant des ordres d'accusé de réception, ACK, avec la station de base (20, 21, 22) et en exécutant une négociation de service avec la station de base (20, 21, 22).

8. Appareil selon la revendication 6, dans lequel le message d'origine inclut un numéro de téléphone fictif constitué uniquement de « 0 ».
